# EUROPEAN PATENT SPECIFICATION

(11) **EP 2 461 159 B1**
(45) Date of publication and mention of the grant of the patent: **25.10.2017**
(21) Application number: 10193535.1
(22) Date of filing: 02.12.2010
(51) Int. Cl.: G01N 29/036

(54) **Method of fabricating sensors having functionalized resonating beams**
Verfahren zur Herstellung von funktionalisierten, resonanten Cantilever-Sensoren
Procédé de fabrication de capteurs dotés de cantilevers résonants fonctionnalisés

(43) Date of publication of application: 06.06.2012
(73) Proprietor: Honeywell Romania S.R.L., 014459 Bucharest (RO)
(72) Inventor: Cobianu, Cornel. P., 061672 Bucharest (RO)
(74) Representative: Fox-Male, Nicholas Vincent Humbert

(56) References cited:
- WO-A1-00/66266
- US-A- 5 694 740
- US-A1- 2009 193 874
- CAMPBELL ET AL: "Piezoelectric-excited millimeter-sized cantilever (PEMC) sensors detect Bacillus anthracis at 300spores/mL", BIOSENSORS AND BIOELECTRONICS, ELSEVIER BV, NL, vol. 21, no. 9, 15 March 2006 (2006-03-15) , pages 1684-1692, XP005298085, ISSN: 0956-5663, DOI: 10.1016/J.BIOS.2005.08.001

## Description

### Background

The global efforts on preserving the health of the planet are focused in some key area like global warming and environmental air quality. One aspect of improving environmental air quality relates to technologies where the gases (e.g. carbon dioxide) that are released from manufacturing processes are captured and sequestered.

Capturing and sequestering gasesmay in the near future involve tightly controlled processes that include continuous real-time monitoring of emissions. The processes and monitoring that are typically associated with capturing and sequestering gases often require high cost-high power sensors.

One potential technology that may be utilized to produce low-cost and low-power sensors involves integrated resonant sensing technology. This integrated sensing technology is based on vibrating beams that are functionalized for chemisorptive carbon dioxide capture. The beams are typically doubly clamp (nano)beams, cantilever (nano)beams or even nanowires. The beams change their resonance frequency proportional to the amount of gas adsorbed on the beam.

These functionalized resonant sensing beams are typically located on the same chip with an integrated circuit for processing signals from the carbon dioxide sensor. A typical single silicon wafer having diameter of 400 mm may contain hundreds of thousands of on-chip carbon dioxide Nano-Electro-Mechano Sensors and Integrated Circuits (NEMSIC) that communicate with the readout integrated circuit.

One of the drawbacks with existing resonant NEMSIC gas sensing systems may relates to an inability to mass produce such systems. One of the difficulties that is associated with mass producing such systems is the low thermal tolerance of the functionalized resonating beams that are typically a primary component in these types of sensors. The low thermal tolerance is due to the fact that the functionalized resonating beams are usually made of organic materials whose chemical stability deteriorates at temperatures higher than 60-70°C. Since many manufacturing methods require temperate above 60-70°C, it becomes difficult to mass produce sensors that include functionalized resonating beams.

There is a need for a method of fabricating sensors that include functionalized resonating beams which allows (i) preparation of sensing layers in functionalized resonating beams;(ii) cost effective high volume packaging of the sensors, (iii) compatibility with the thermal limits tolerated by the organic material that is used in functionalized resonating beams; and (iv) the sensing surface to haveaccess to the ambient air in order detecta reversible reaction between a particular gas in the ambient air and the functionalized resonating beams.

US Patent Publication No. US 5694740A describes methods for reducing stiction of surfaces of a packaged die, particularly for hermetically sealed packages such as cerdip (ceramic dual inline package), cerpac, or a header. It focuses on a die including a micromachined accelerometer, and uses a fine layer of water, silicone or organic wax. Temperatures over 150°C are required for the processes, often over 430°C.

### Summary of the Invention

The present invention is defined by the appended claims.

### Brief Description of the Drawings

FIG. 1 is a flow diagram illustrating an example method fabricating a sensor.
FIG. 2 illustrates an example substrate wafer that includes multiple chips where each chip has at least one suspended beam and the figure includes an enlarged portion that illustrates one example chip.
FIG. 3 illustrates an example chip that includes at least one suspended beam.
FIG. 4 is a section view of the chip shown in FIG. 3 taken along line 3-3.
FIG. 5 illustrates the example chip shown in FIG. 3 where the chip is covered with an adhesive layer.
FIG. 6 is a section view of the chip shown in FIG. 5 taken along line 6-6.
FIG. 7 illustrates the example chip shown in FIG. 3 where a cover has been placed onto the adhesive layer.
FIG. 8 is a section view of the chip shown in FIG. 7 taken along line 7-7.
FIG. 9 illustrates a portion of the cover wafer that is used in the chip shown in FIGS. 7 and 8.
FIG. 10 is a section view of the portion of the cover wafer shown in FIG. 9 taken along line 10-10.

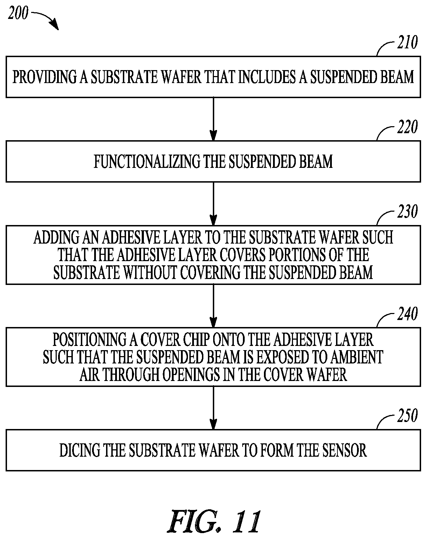

FIG. 11 is a flow diagram illustrating another example method fabricating a sensor.

### Detailed Description

In the following description, reference is made to the accompanying drawings that form a part hereof, and in which is shown by way of illustration specific embodiments which may be practiced. These embodiments are described in sufficient detail to enable those skilled in the art to practice the invention, and it is to be understood that other embodiments may be utilized and that structural, electrical, and optical changes may be made without departing from the scope of the present invention. The following description of example embodiments is, therefore, not to be taken in a limited sense, and the scope of the present invention is defined by the appended claims.

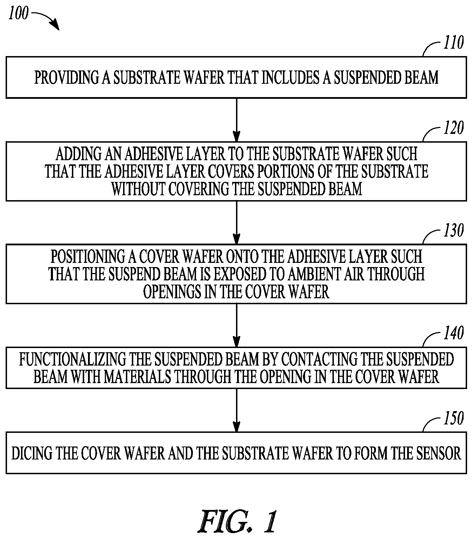

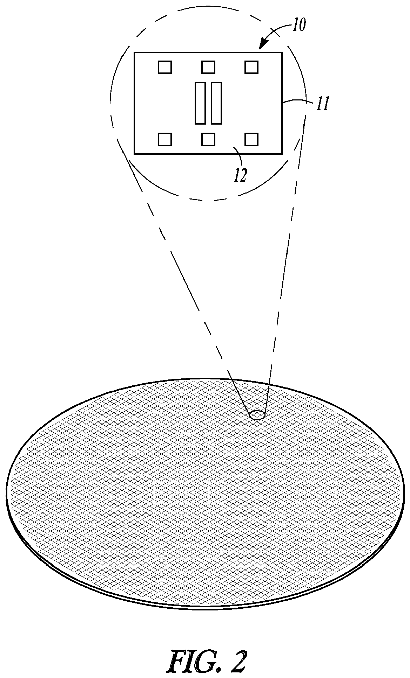

FIG. 1 illustrates an example method [100] of fabricating a sensor 10. The method includes [110] providing a substrate wafer 12 that includes at least one suspended beam 14 (e.g., a substrate wafer 12 that includes CMOS circuitry). An example substrate wafer 12 is shown in FIG. 2 with one chip 11 on the substrate wafer 12 enlarged for purpose of clarity.

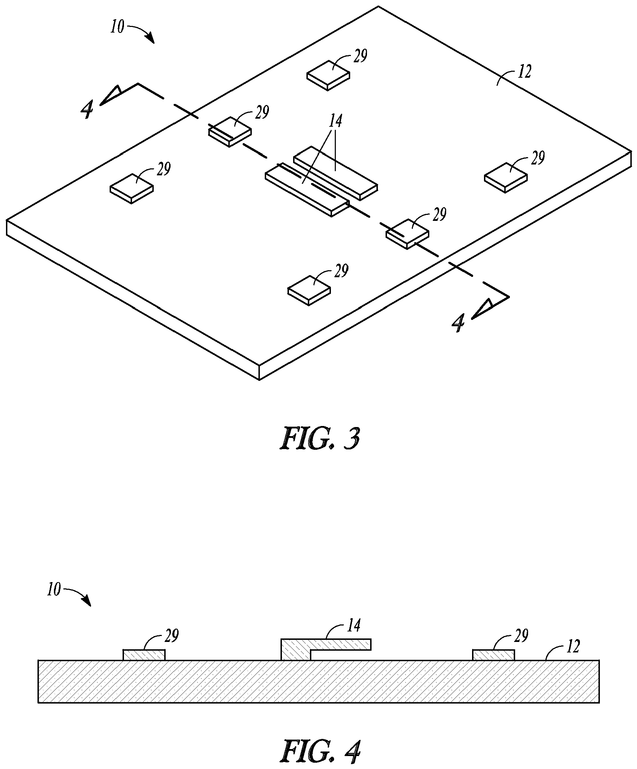

FIGS. 3-10 also illustrate one chip only for purposes of clarity even though many of steps described herein refer to wafer level processing. It should be noted that even though FIGS. 3 and 4 show the substrate wafer 12 as having two suspended beams 14, the substrate wafer 12 may include any number of suspended beams 14.

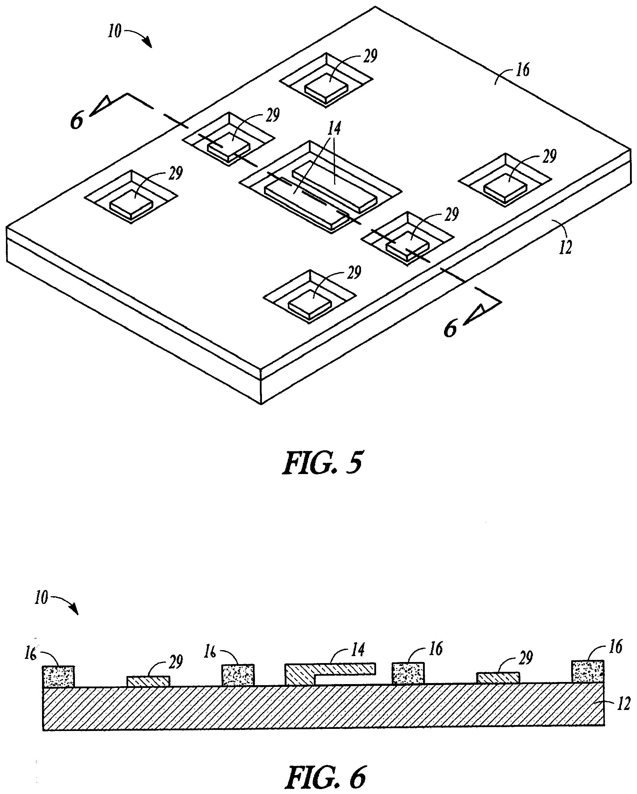

Referring again to FIG. 1, the method [100] further includes [120] adding an adhesive layer 16 to the substrate wafer 12 such that the adhesive layer 16 covers portions of the substrate wafer 12 without covering the suspended beams 14. As an example, the adhesive layer 16 may be added by patterned adhesive polymer bonding. As shown most clearly in FIGS. 5 and 6, the suspended beams 14 are exposed through openings 17 in the adhesive layer 16 for subsequent processing.

In some embodiments, [120] adding an adhesive layer 16 to the substrate wafer 14 such that the adhesive layer 16 covers portions of the substrate wafer 12 without covering the suspended beams 14 includes curing the adhesive layer before functionalizing the suspended beams 14.The adhesive layer 16 may be deposited on the substrate wafer 12 by direct printing or photolithographic methods.

The adhesive layer 16 may be a thermosetting or thermoplastic polymer layer. Some example thermosetting polymers include benzene-cyclo-butene and other materials (e.g., liquid crystal polymer or polyimides).

In the illustrated example embodiments, the bond pad 29 areas and sensing and reference beams area are not covered with adhesive layer 16. All the rest of the chip is covered with the adhesive layer 16 to promote bonding stability and heat transfer outside of the silicon chip.

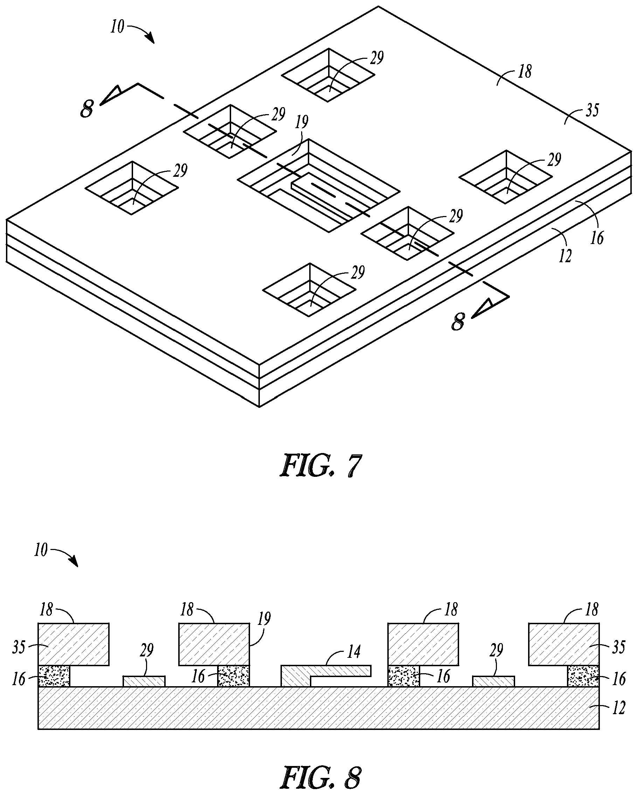

Referring again to FIG. 1, the method [100] further includes [130] positioning a cover wafer 18 onto the adhesive layer 16 such that the suspend beams 14are exposed to ambient air through openings 19 in the cover wafer 18.As shown most clearly in FIGS. 7 and 8, the suspend beams 14 are exposed to ambient air through openings 19 in the cover wafer 18.

In some embodiments, [130] positioning a cover wafer 18 onto the adhesive layer 16 such that the suspend beams 14 are exposed to ambient air through openings 19 in the cover wafer 18 includes fabricating the openings 19 in the cover wafer 18.

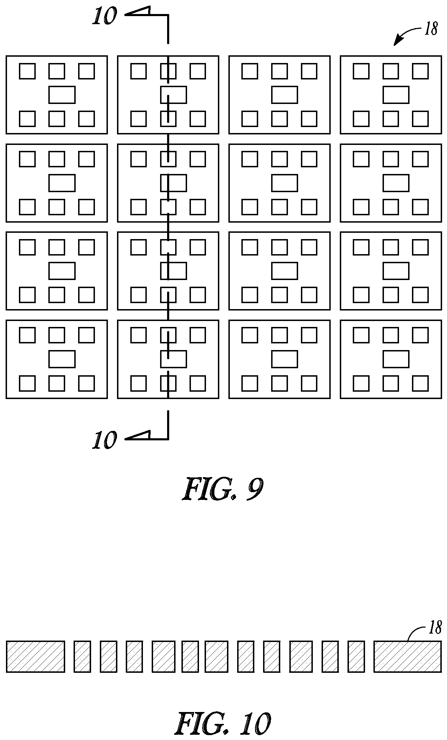

Referring again to FIG. 1, the method [100] further includes [140] functionalizing the suspended beams 14 by contacting the suspended beams 14 with materials through the openings19 in the cover wafer 18. FIGS. 9 and 10 illustrate an example cover wafer 18 that may be used in the method [100].

According to the invention, functionalizing the suspended beams 14 by contacting the suspended beams 14 with materials through the openings 19 includes direct printing of the materials through the openings 19 in the cover wafer 18. As an example, direct printing of the materials may be done with high positioning accuracy by means of dip pen nanolithography (DPN) tools.

Functionalizing the suspended beams 14 after the cover wafer 18 has been bonded to the adhesive layer 16 prevents having the functionalized surface of the functionalized suspended beams 14 exposed to undesirably high temperatures that are used during the bonding process.

In some embodiments, [140] functionalizing the suspended beam by contacting the suspended beams 14 with materials through the openings 19 in the cover wafer 18 includes drying the deposited material. As an example, drying the deposited material may include changing the material from a liquid to a solid.

The technology associated with functionalizing the suspended beams 14 will depend in part on the type of gas that is to be detected by the sensor 10. As discussed above, only the regions of the chip where the suspended beams 14 are located is exposed for the whole sequence of chemical processes that are needed for functionalization. All the other parts of the chip are protected by the substrate wafer 12, adhesive layer 16 and the cover wafer 18, which are chemically resistant to processes used for functionalization (e.g., silicon functionalization).

As shown in FIG. 1, the method [100] further includes [150] dicing the cover wafer and the substrate wafer to form the sensor. As an example, the cover wafer 18 may be formed of silicon such that fabricating the openings 19 in the cover wafer 18 includes anistropic etching of the cover wafer 18.

### Method A

I. Processing of the silicon CMOS wafer (W1) containing (all) resonant structures, as per technology requirements. This can be either a bulk CMOS or a SOI-CMOS approach, and where alignment keys to be present on the wafer for its further alignment.
   Some example final steps include: 1. The release of the suspended silicon sensing beams and the reference beam. 2. The selective application of the adhesion promoter in the regions where the adhesive for bonding will be applied. This can be performed by maskless direct printing methods. 3. The selective application of the intermediate adhesive polymer layer on entire wafer W1 (FIG. 2), above the adhesion promoter areas from above, by means of the direct printing methods (preferred embodiment), or screen printing or via a lithographic process, in which case, the spin coating on the whole surface is followed by selective etching process. As a CMOS compatible, low cost, high bond strength polymer adhesive one can use thermosetting polymers like BCB (benzo-cyclo-butene) which is thermally curable polymer becoming mechanically and chemically very strong material after cross linking polymerization process, which happens due thermal activation process. Such a polymer adhesive layer has to have a thickness in the range of 1.5-3 micrometers which can tolerate structured surface of CMOS processed silicon wafer and still assure a reasonable good chemical separation between the exposed and non-exposed regions to the external ambient. 4. Pre-curing of the BCB layer in oxygen free ambient at temperatures between 190 and 200°C for 30 minutes, in order to reach a partial polymerization level of about 30-50%, only. During this stage the solvents and volatile components are removed from the BCB, so that to avoid any such process during curing to occur, which will determine void formation and low bond strength. This soft backing will help the BCB to deform and wet the surface of substrate and thus to follow the topography of Si wafer W1, which is already containing the CMOS circuitry as well as excitation and detection circuitry for resonant operation of the sensor.
II. Processing of the lid/cover wafer (W2) (made of Si or glass wafer), consisting of the following steps: 1. Fabrication of the through-the wafer-holes in the cover wafer (W2) for creating access zones to the bond pad and sensing area by selective masking and deep etching process (either KOH etching or deep reactive ion etching (DRIE) for Si wafer or DRIE or sand blasting for glass wafer. 2. The selective application of the adhesion promoter in the regions where the adhesive material for bonding will be applied. This can be done by maskless direct printing methods.
III. Wafer-level adhesive bonding of W1 and W2, consisting of the following steps: 1. Bringing the wafers W1 and W2 to the bond tool and placing them on the bond fixture for transferring them to the bond chamber for wafer to wafer alignment and bonding. 2. Vacuuming the bond chamber to a vacuum level of 10-3mbar and then applying a bonding pressure of about 0.4 MPa., while the wafer stack is heated to about 250°C for 30-560 minutes to perform the curing process for final BCB based adhesive wafer bonding.
IV. V. Wafer dicing for chips separation.

### Method B

The steps are as follows: I. Full processing of silicon wafer W1 consisting of FEOL and BEOL steps, as follows. 1. CMOS circuitry fabrication, MEMS beams release and functionalization, all these being performed before W1 packaging. 2. Selective application of the adhesion promoter on W1 in the regions of the future bonding. 3. Selective application of the UV curable adhesive thermosetting polymer (e.g., NEA 121 UV adhesive from Norland product or SU8 epoxy).
II. Processing of cover wafer W2, which is made of glass so that to be transparent to UV light, as described above at Method A and shown in (FIG. 3).
III. Dicing of the wafer W2 with standard processes.
IV. Chip to wafer bonding, where the known good glass dies are to be bonded to known good dies from wafer W2, as follows: 1. Pick and place process for putting the glass chips (cover) on the silicon sensor chips by proper alignment before bonding. 2. Adhesive curing in UV light for 10 minutes provided by an UV lamp illuminating with 14 mW/cm2 (e.g., Lamp from Spectronics, model SB-100P).

Dicing the wafer W1 and separation of known good chips from the rest of the chips on the wafer W1. Within this method, the entire CMOS circuitry, MEMS and sensing functionalization are already done on the wafer W1, before the packaging process to begin. The packaging process needs to preserve the quality of the functionalized (organic) layer, so this means a room temperature bonding should be practically used. This approach has the advantage of packaging only the good dies, after wafer level testing is done on each wafer.

As used herein, a "functionalized beam" means a beam that is capable of absorbing and/or reacting with a particular gas. It should be noted that a functionalized beam mayinclude functionalized surfaces 14, 18 that are formed as part of a layer or coating that is added to the beams.

## Claims

1. A method of fabricating a sensor comprising:
providing a substrate wafer 12 that includes a plurality of functionalized resonant sensing beams with integrated circuits for processing signals from the sensing beams;
providing a cover wafer 18;
fabricating openings 19 in the cover wafer 18;
dicing the cover wafer 18 to form a plurality of cover chips 18;
functionalizing the suspended beams with materials through the opening in the cover wafer by direct printing of the materials through the openings in the cover wafer;
adding an adhesive layer 16 to the substrate wafer 12 such that the adhesive layer 16 covers portions of the substrate wafer 12 without covering the beam 14;
positioning at least one of the cover chips 18 onto the adhesive layer 16 such that the suspended beam 14 is exposed to ambient air through openings in the cover chip 18;
dicing the substrate wafer 12 to form sensor chips, each comprising a plurality of functionalized resonant sensing beams with an integrated circuit for processing signals from the sensing beams.

2. The method of claim 1, wherein functionalizing the suspended beam 14 includes direct printing of materials onto the suspended beam 14.

3. The method of claim 2 wherein direct printing of materials onto the beam 14 includes direct printing the materials using dip pen nanolithography.

4. The method of claim 1 wherein providing a substrate wafer 12 that includes a suspended beam 14 includes providing a substrate wafer 12 that includes CMOS circuitry.

## Patentansprüche

1. Verfahren zum Herstellen eines Sensors, umfassend:
Bereitstellen eines Substratwafers 12, der eine Vielzahl von funktionalisierten resonanten Sensorstäben mit integrierten Schaltkreisen zum Verarbeiten von Signalen von den Sensorstäben umfasst;
Bereitstellen eines Abdeckwafers 18;
Herstellen von Öffnungen 19 in dem Abdeckwafer 18;
Vereinzeln des Abdeckwafers 18, um eine Vielzahl von Abdeckchips 18 zu bilden;
Funktionalisieren der abgehängten Stäbe mit Materialien durch die Öffnung in dem Abdeckwafer, indem die Materialien direkt durch die Öffnungen in dem Abdeckwafer gedruckt werden;
Hinzufügen einer Adhäsionsschicht 16 zu dem Substratwafer 12, sodass die Adhäsionsschicht 16 Anteile des Substratwafers 12 abdeckt ohne den Stab 14 abzudecken;
Platzieren mindestens eines der Abdeckchips 18 auf die Adhäsionsschicht 16, sodass der abgehängte Stab 14 durch die Öffnungen in dem Abdeckchip 18 der Umgebungsluft ausgesetzt wird;
Vereinzeln des Substratwafers 12, um Sensorchips zu bilden, die jeweils eine Vielzahl von funktionalisierten resonanten Sensorstäben mit einem integrierten Schaltkreis zum Verarbeiten von Signalen von den Sensorstäben umfassen.

2. Verfahren nach Anspruch 1, wobei das Funktionalisieren des abgehängten Stabs 14 ein direktes Drucken der Materialien auf den abgehängten Stab 14 umfasst.

3. Verfahren nach Anspruch 2, wobei das direkte Drucken von Materialien auf den Stab 14 ein direktes Drucken der Materialien mithilfe einer Dip-Pen-Nanolithografie umfasst.

4. Verfahren nach Anspruch 1, wobei das Bereitstellen eines Substratwafers 12, der einen abgehängten Stab 14 umfasst, ein Bereitstellen eines Substratwafers 12 umfasst, der eine CMOS-Schaltung umfasst.

## Revendications

1. Procédé de fabrication d'un capteur comprenant les étapes suivantes :
l'obtention d'une tranche substrat 12 qui comporte une pluralité de poutres de détection résonantes fonctionnalisées avec des circuits intégrés pour traiter les signaux provenant des poutres de détection ;
l'obtention d'une tranche de couverture 18 ;
la fabrication d'ouvertures 19 dans la tranche de couverture 18 ;
la découpe de la tranche de couverture 18 pour former une pluralité de puces de couverture 18 ;
la fonctionnalisation des poutres suspendues avec des matériaux à travers l'ouverture dans la tranche de couverture par impression directe des matériaux à travers les ouvertures dans la tranche de couverture ;
l'ajout d'une couche adhésive 16 à la tranche substrat 12 de telle sorte que la couche adhésive 16 recouvre des parties de la tranche substrat 12 sans recouvrir la poutre 14 ;
le positionnement d'au moins une des puces de couverture 18 sur la couche adhésive 16 de telle sorte que la poutre suspendue 14 soit exposée à l'air ambiant à travers les ouvertures dans la puce de couverture 18 ;
la découpe de la tranche substrat 12 pour former des puces de détection, chacune comprenant une pluralité de poutres de détection résonantes fonctionnalisées avec un circuit intégré pour traiter les signaux provenant des poutres de détection.

2. Procédé de la revendication 1, dans lequel la fonctionnalisation de la poutre suspendue 14 comporte l'impression directe de matériaux sur la poutre suspendue 14.

3. Procédé de la revendication 2 dans lequel l'impression directe de matériaux sur la poutre 14 comporte l'impression directe des matériaux par nanolithographie stylo à plume.

4. Procédé de la revendication 1 dans lequel l'obtention d'une tranche substrat 12 qui comporte une poutre suspendue 14 comporte l'obtention d'une tranche substrat 12 qui comporte un circuit CMOS.
